(19)

Europäisches Patentamt
European Patent Office
Office européen des brevets

(11) **EP 2 172 858 A1**

(12) **EUROPEAN PATENT APPLICATION**

(43) Date of publication:
**07.04.2010 Bulletin 2010/14**

(51) Int Cl.:
***G06F 17/50*** *(2006.01)*

(21) Application number: **09152736.6**

(22) Date of filing: **12.02.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **27.05.2008 JP 2008138312**

(71) Applicant: **Fujitsu Ltd.**
**Kawasaki-shi, Kanagawa 211-8588 (JP)**

(72) Inventor: **Tsubamoto, Daita**
**Kawasaki-shi, Kanagawa 211-8588 (JP)**

(74) Representative: **Fenlon, Christine Lesley**
**Haseltine Lake LLP**
**Lincoln House, 5th Floor**
**300 High Holborn**
**London WC1V 7JH (GB)**

(54) **Circuit simulation apparatus and method, medium containing circuit simulation program**

(57)  A circuit simulation apparatus includes a first acquisition unit that acquires information on a jitter transfer function of a jitter pass element with respect to a predetermined frequency band, a second acquisition unit that acquires information pertaining to input jitter to the jitter pass element, a first calculation unit that determines a jitter frequency based on the information acquired by the first acquisition unit or the second acquisition unit to calculate a jitter transfer function value which is a value of the jitter transfer function acquired by the first acquisition unit at the jitter frequency, and a second calculation unit that calculates output jitter from the jitter pass element based on the information pertaining to the input jitter acquired by the second acquisition unit and the jitter transfer function value calculated by the first calculation unit.

FIG. 2

EP 2 172 858 A1

**Description**

**FIELD**

The present invention relates to a circuit simulation apparatus for performing a circuit simulation pertaining to jitter that passes through an element, a medium containing a circuit simulation program, a circuit simulation method.

**BACKGROUND**

The amount of information processing demanded of digital electronic apparatuses has been on the increase in recent years. Signal speeds inside the apparatuses have increased accordingly, with the propensity for smaller transmission margins. It has therefore been necessary to estimate the transmission margins accurately, putting a large number of factors for margin deterioration together. In particular, a phase shift (jitter) in elements and transmission systems has been a factor of ever increasing significance.

Among the conventional technologies is a method of analyzing a transmission line, in which a rough estimation of the amount of jitter is calculated from an eye pattern that is obtained by transmitting short bit patterns through the transmission line. There is also a measuring apparatus which calculates the jitter transfer function, bit error rate, and jitter tolerance of a Device Under Test (DUT) with high efficiency (refer to, e.g., Patent Document 1: Japanese. Laid-Open Patent Publication No. 2007-292520 and Patent Document 2: International Publication Pamphlet No. WO 2003/073680).

It is not possible, however, to model elements that have a jitter transfer function (jitter pass elements), such as an optical module, buffer, and repeater, by using ordinary waveform simulators. As employed herein, the jitter transfer function of a jitter pass element refers to the ratio of output jitter to input jitter thereof, and is expressed as a frequency characteristic.

A signal transmission system is thus divided into systems preceding and subsequent to a jitter pass element, and the systems are subjected to respective circuit simulations. The jitter determined by the circuit simulation on the system in the preceding stage is then added to the jitter determined by the circuit simulation on the system in the subsequent stage, whereby the result of the entire circuit simulation is obtained.

This circuit simulation method has a significant drawback in terms of man-hours due to reasons such as complicated modeling and the incapability of comprehensive simulation.

**SUMMARY**

It is desirable to provide a circuit simulation apparatus for performing a circuit simulation on a circuit including a jitter pass element with high efficiency, a medium containing a circuit simulation program, a circuit simulation method, a medium containing a circuit simulation modeling program, an electronic circuit, and an electronic circuit board.

According to embodiments of an aspect of the invention, there is provided a circuit simulation apparatus for performing a circuit simulation using a jitter pass element model that is a model of a jitter pass element, the jitter pass element being an element for jitter to pass through, the apparatus including: a first acquisition unit that acquires information on a jitter transfer function of the jitter pass element with respect to a predetermined frequency band; a second acquisition unit that acquires information pertaining to input jitter to the jitter pass element; a first calculation unit that determines a jitter frequency based on the information acquired by the first acquisition unit or the second acquisition unit to calculate a jitter transfer function value which is a value of the jitter transfer function acquired by the first acquisition unit at the jitter frequency; and a second calculation unit that calculates output jitter from the jitter pass element based on the information pertaining to the input jitter acquired by the second acquisition unit and the jitter transfer function value calculated by the first calculation unit.

The desirable outcomes and advantages of the invention will be realized and attained by means of the elements and combinations particularly pointed out in the claims.

It is to be understood that both the foregoing general description and the following detailed description are exemplary and explanatory and are not restrictive of the invention, as claimed.

**BRIEF DESCRIPTION OF DRAWINGS**

Preferred features of the present invention will now be described, purely by way of example, with reference to the accompanying drawings, in which:-

FIG. 1 is a block diagram illustrating an example of the configuration of a circuit simulation apparatus according to a first embodiment of the present invention;

FIG. 2 is a block diagram illustrating an example of the configuration of a jitter pass element model 7 according to the first embodiment;

FIG. 3 is a flowchart illustrating an example of the operation of the circuit simulation apparatus according to the first embodiment;

FIG. 4 is a diagram illustrating an example of a parameter input screen which is displayed by a parameter setting unit 11 according to the first embodiment;

FIG. 5 is a diagram illustrating an example of input jitter amount acquisition processing according to the first embodiment;

FIG. 6 is a diagram illustrating an example of cross point duration detection processing according to the first embodiment;

FIG. 7 is a flowchart illustrating an example of the cross point duration detection processing according to the first embodiment;

FIG. 8 is a diagram illustrating an example of minimum jitter tolerance extraction processing according to the first embodiment;

FIG. 9 is a diagram illustrating an example of target jitter frequency extraction processing according to the first embodiment;

FIG. 10 is a diagram illustrating an example of target jitter transfer function value calculation processing according to the first embodiment;

FIG. 11 is a diagram illustrating an example of output jitter amount calculation processing according to the first embodiment;

FIG. 12 is a diagram illustrating an example of output waveform generation processing according to the first embodiment;

FIG. 13 is a block diagram illustrating an example of the configuration of a circuit simulation apparatus according to a second embodiment of the present invention;

FIG. 14 is a block diagram illustrating an example of the configuration of a jitter pass element model 7b according to the second embodiment;

FIG. 15 is a diagram illustrating an example of jitter transfer function value calculation processing according to the second embodiment;

FIG. 16 is a block diagram illustrating an example of the configuration of a circuit simulation apparatus according to the second embodiment;

FIG. 17 is a block diagram illustrating an example of the configuration of a jitter pass element model 7c according to a third embodiment of the present invention;

FIG. 18 is a flowchart illustrating an example of the operation of the jitter pass element model 7c according to the third embodiment;

FIG. 19 is a diagram illustrating an example of input frequency component acquisition processing according to the third embodiment;

FIG. 20 is a diagram illustrating an example of output frequency component calculation processing according to the third embodiment;

FIG. 21 is a chart illustrating equations for an example of the output frequency component calculation processing according to the third embodiment; and

FIG. 22 is a chart illustrating an equation for an example of output jitter amount calculation processing according to the third embodiment.

## DESCRIPTION OF EMBODIMENT(S)

Hereinafter, embodiments of the present invention will be described with reference to the drawings.

### [First Embodiment]

Description will be given of the configuration of a circuit simulation apparatus according to the present embodiment.

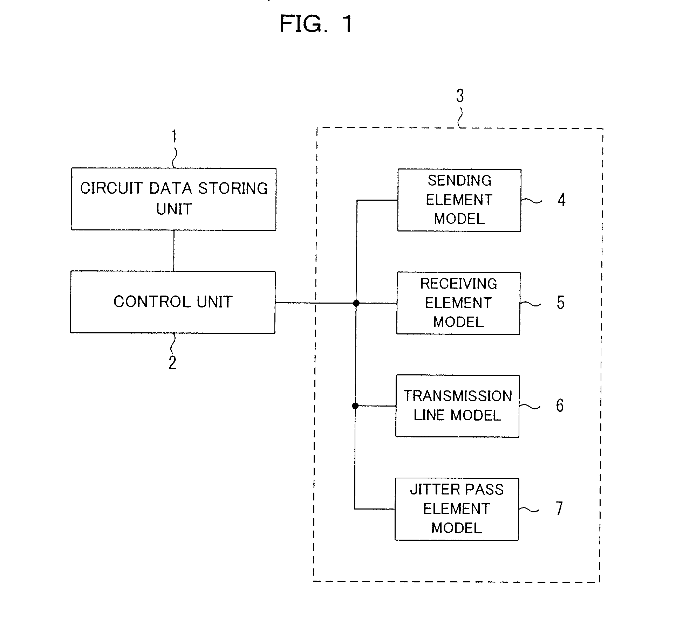

FIG. 1 is a block diagram illustrating an example of the configuration of the circuit simulation apparatus according to a first embodiment of the present invention. The circuit simulation apparatus includes a circuit data storing unit 1, a control unit 2, and a model library 3. The model library 3 includes a sending element model 4, a receiving element model 5, a transmission line model 6, and a jitter pass element model 7. Hereinafter, a device to be subjected to a circuit simulation will be referred to as a relevant device. The relevant device includes a sending element, a transmission line in the subsequent stage, a jitter pass element in the subsequent stage, a transmission line in the subsequent stage, and a receiving element in the subsequent stage. The jitter pass element in the relevant device will be referred to as a relevant element.

Circuit data on the relevant device which is designed by using the models in the model library 3 is stored in the circuit data storing unit 1. The control unit 2 controls a circuit simulation on the circuit data stored in the circuit data storing unit 1, by using the models in the model library 3. An example of the circuit simulation apparatus is a computer having a CPU (Central Processing Unit) and a storage device. An example of the circuit data storing unit 1 is the storage device. Examples of the control unit 2 and the model library 3 are programs which are stored in the storage device and executed by the CPU.

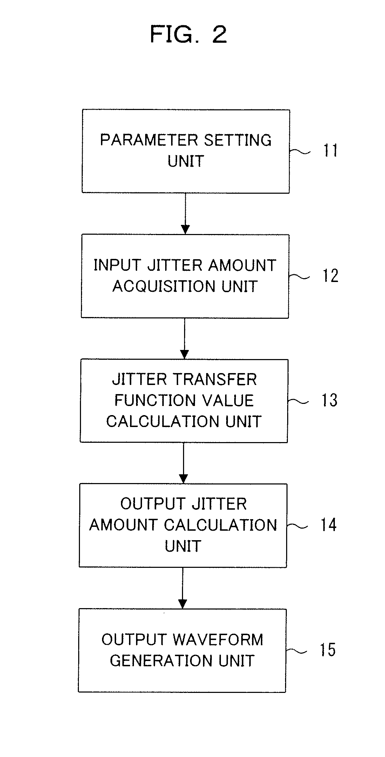

FIG. 2 is a block diagram illustrating an example of the configuration of the jitter pass element model 7 according to the first embodiment. The jitter pass element model 7 includes a parameter setting unit 11, an input jitter amount acquisition unit 12, a jitter transfer function value calculation unit 13, an output jitter amount calculation unit 14, and an output waveform generation unit 15. The first acquisition unit corresponds to the parameter setting unit 11. The second acquisition unit corresponds to the input jitter amount acquisition unit 12. The first calculation unit corresponds to the jitter transfer function value calculation unit 13. The second calculation unit corresponds to the output jitter amount calculation unit 14. The waveform generation unit corresponds to the output waveform generation unit 15.

Next, the operation of the circuit simulation apparatus according to the present embodiment will be overviewed.

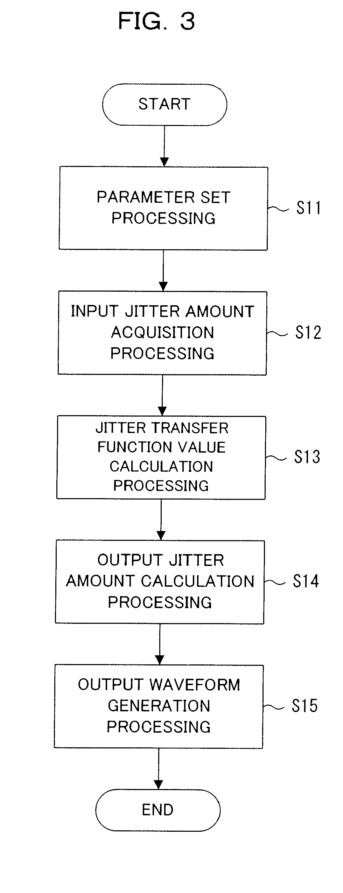

FIG. 3 is a flowchart illustrating an example of the operation of the circuit simulation apparatus according to the first embodiment. The parameter setting unit 11 performs parameter set processing (S11). Next, the input jitter amount acquisition unit 12 performs input jitter amount acquisition processing (S12). Then, the jitter transfer function value calculation unit 13 performs jitter transfer function value calculation processing (S13). Subsequently, the output jitter amount calculation unit 14 performs output jitter amount calculation processing (S14). Then, the output waveform generation unit 15 performs output waveform generation processing (S15).

The parameter set processing will be described below.

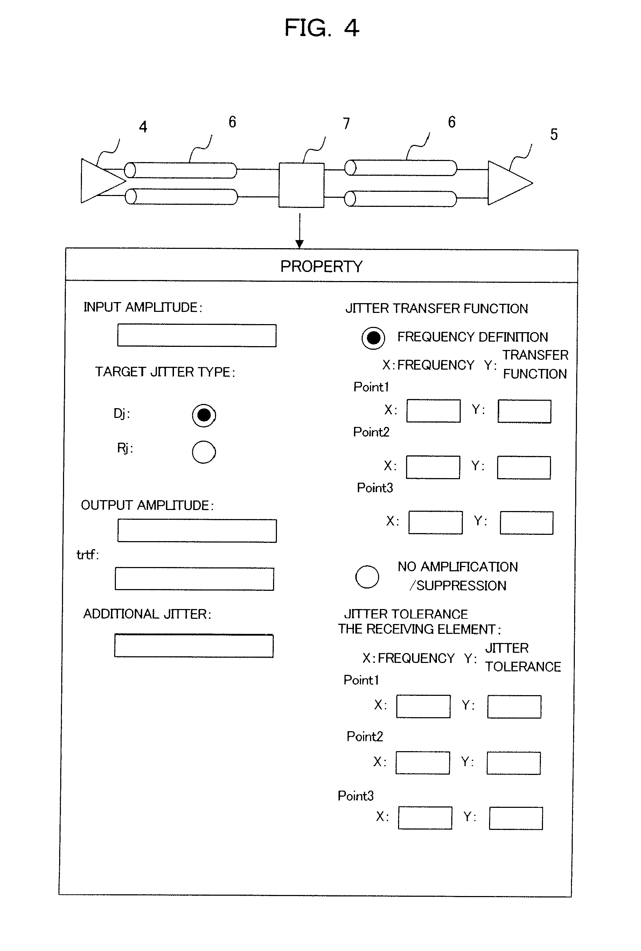

The parameter setting unit 11 displays a parameter input screen, and sets the attributes of the jitter pass element model 7 of the relevant element according to user inputs on the parameter input screen. FIG. 4 is a diagram illustrating an example of the parameter input screen which is displayed by the parameter setting unit 11 according to the first embodiment. FIG. 4 illustrates the simulation model of the relevant device, which includes: a sending element model 4; a transmission line model 6 in the subsequent stage; a jitter pass element model 7, or relevant element model, in the subsequent stage; a transmission line model 6 in the subsequent stage; and a receiving element model 4 in the subsequent stage. FIG. 4 illustrates the parameter input screen for a user to input the parameters of the jitter pass element model 7. For the attributes of the jitter pass element model 7, the parameter setting unit 11 sets the following parameters:

(1) The limit values of input amplitude (MIN, MAX);
(2) The jitter transfer function of the relevant element;
(3) Additional jitter;
(4) The waveform characteristic of the output signal;
(5) The jitter tolerance of the receiving element; and
(6) Target jitter type.

When the limit values of the input amplitude are input by the user, the parameter setting unit 11 sets these values as an attribute of the jitter pass element model 7.

When the coordinates of a change point or change points in the frequency characteristic of a jitter transfer function are input by the user, the parameter setting unit 11 sets the jitter transfer function as an attribute of the jitter pass element model 7. The jitter transfer function is a frequency characteristic expressed by a line graph, being composed of catalog data or measured data.

The parameter setting unit 11 also displays the jitter transfer function of an element without jitter amplification or suppression, where input jitter is transferred to the output directly, as an alternative on the parameter input screen. When this alternative is selected by the user, the parameter setting unit 11 sets a jitter transfer function that is 1 to across the entire frequency range, as an attribute of the jitter pass element model 7. This parameter set processing makes it possible to discriminate an element without jitter amplification or suppression for the sake of reduced man-hours for input.

In some jitter pass elements, jitter may be added fixedly because of noise and other factors. In this case, the amount of the jitter to be added (additional jitter) is predetermined. When additional jitter is input by the user, the parameter setting unit 11 therefore sets the value as an attribute of the jitter pass element model 7.

The parameter setting unit 11 sets the waveform characteristic of an output signal as an attribute of the jitter pass element model 7 according to user input. The waveform characteristic of the output signal includes amplitude and rise/fall time.

When the jitter tolerance of the receiving element is input by the user from the parameter input screen, the parameter setting unit 11 sets it as an attribute of the jitter pass element model 7. The jitter tolerance has a frequency characteristic which is expressed by a line graph, and is input in terms of the coordinates of a change point or change points as with the jitter transfer function. This parameter set processing makes it possible to include the jitter tolerance of the receiving element as one of the conditions for calculating the transfer function of the jitter pass element. The frequency characteristic of the jitter tolerance can be input in terms of change points.

The parameter setting unit 11 sets target jitter type as an attribute of the jitter pass element model 7 according to user input. The target jitter type refers to the type of intended jitter among the output jitters of the sending element in the preceding stage of the relevant element. The target jitter type is selected from Dj and Rj. This selection is made by the user, based on such factors as the function of the relevant device and the frequency of power supply noise that occurs on the printed circuit board (the jitter frequency of the sending element which typically coincides with the frequency of the power supply noise). Both of Dj and Rj may be selected, and neither may be selected.

This parameter set processing makes it possible to select the type(s) of jitter(s) to be passed, from among the jitters of the sending element in the preceding stage. Some jitter-suppressing elements are considered to suppress all Dj in the element characteristic. For such elements, Dj can be excluded from calculation targets beforehand so that overestimation is avoided of the amount of jitter to pass.

The input jitter amount acquisition processing will be described below.

When expressing a jitter pass phenomenon, it is first necessary to identify the jitters included in the input signal. Actual waveforms contain various kinds of jitter components (such as random jitter and deterministic jitter). Typical circuit simulation programs, on the other hand, often express jitters that occur when a signal is transmitted through a transmission line and that are output from the sending element separately from each other.

Of these, the output jitter of the sending element in the preceding stage is defined in the catalog specifications of the sending element, and is typically set in the sending element model as parameters. The input jitter amount acquisition unit 12 reads and recognizes the parameters of the sending element model as variables (variable processing).

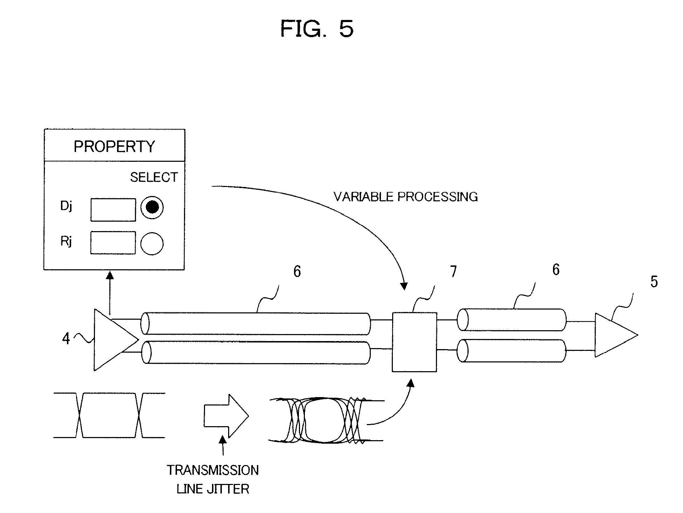

FIG. 5 is a diagram illustrating an example of the input jitter amount acquisition processing according to the first embodiment. The simulation model illustrated in FIG. 5 is the same as that of FIG. 4. FIG. 5 illustrates an attribute (property) display screen of the sending element, the output waveform of the sending element, and the input waveform of the relevant element. Among the attributes of the sending element, the Dj and Rj values are preset in the sending element model. The selection of Dj and/or Rj indicates the target jitter type which is set as a property of the jitter pass element by the parameter set processing.

According to this input jitter amount acquisition processing, it is possible to divide the jitter input to the jitter pass element into the output jitter of the sending element and a transmission line jitter occurring from the transmission line, and process the output jitter as variables. This processing eliminates the need to express the jitter behavior of the sending element, thereby contributing to a reduced amount of calculation.

The transmission line jitter appears as a waveform deterioration due to transmission line loss, and varies with the transmission line loss. Information on the transmission line jitter therefore may not be recognized by variable processing as with the output jitter of the sending element. The input jitter amount acquisition unit 12 observes the eye pattern of the waveform input to the relevant element, and calculates the duration of the area (cross point) where this eye pattern crosses the time axis (cross point duration detection processing), thereby recognizing the cross point duration as the amount of transmission line jitter.

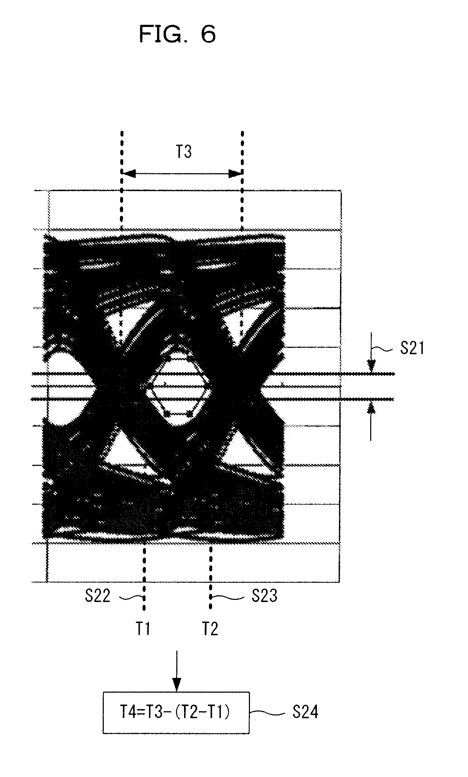

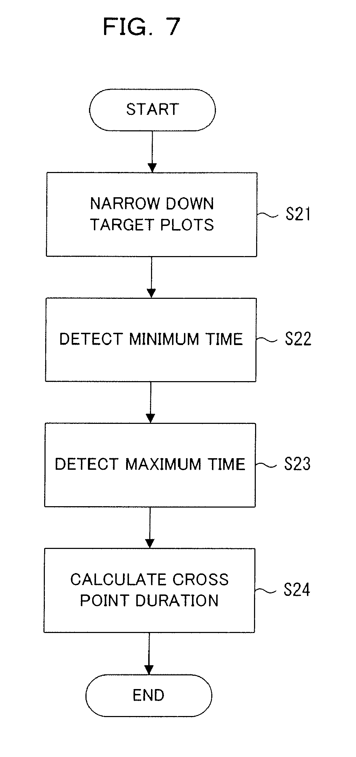

FIG. 6 is a diagram illustrating an example of the cross point duration detection processing according to the first embodiment. This diagram illustrates the eye pattern of a waveform input to the relevant element. FIG. 7 is a flowchart illustrating an example of the cross point duration detection processing according to the first embodiment. The input jitter amount acquisition unit 12 narrows down target plots in the eye pattern of the waveform input to the relevant element (S21). Next, the input jitter amount acquisition unit 12 detects a plot of minimum time T1 in the opening of the target plots (S22). Then, the input jitter amount acquisition unit 12 detects a plot of maximum time T2 in the opening of the target plots (S23). Subsequently, the input jitter amount acquisition unit 12 calculates the cross point duration T4 = (T3 - (T2 - T1)), where T3 is the period of the input waveform (S24), and ends this flow.

This input jitter amount acquisition processing makes it possible to recognize the transmission line jitter as the input jitter of the jitter pass element, and use it for subsequent processing.

The jitter transfer function value calculation processing will be described below.

The jitter transfer function value calculation processing varies with the types of intended jitter pass elements, which are broadly classified into two types. A first type of jitter pass element superimposes a certain jitter on input jitter before output. A second type of jitter pass element suppresses input jitter with a certain transfer function before output. The jitter transfer function of the first type is 1 to across the entire frequency range.

Next, the jitter transfer function value calculation processing of second type will be described in detail.

For a second type of jitter pass element, the frequency dependence of the jitter transfer function is often given as catalog data or measured data. It is technically quite difficult, however, to express the jitter frequency dependence with ordinary simulation models. The jitter transfer function value calculation unit 13 of the present embodiment determines the target frequency range based on the frequency dependence of the jitter tolerance of a CDR (Clock Data Recovery) circuit in the receiving element at the subsequent stage of the relevant element, and uses a maximum jitter transfer function value in that frequency range.

The jitter transfer function value calculation unit 13 initially performs minimum jitter tolerance extraction processing to extract a point of the minimum jitter tolerance from among the change points of the receiving element's jitter tolerance which is set by the parameter set processing. The specific calculation formula for the minimum jitter tolerance extraction processing is given by the following:

Minimum jitter tolerance = MIN(jitter tolerances in all change points).

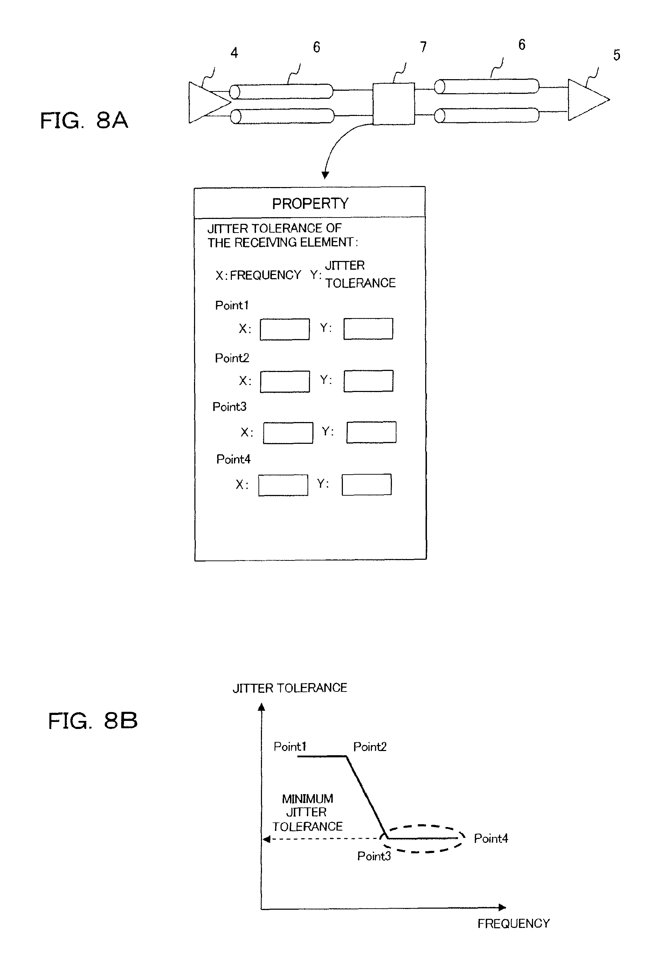

FIG. 8 is a diagram illustrating an example of the minimum jitter tolerance extraction processing according to the first embodiment. The simulation model illustrated in FIG. 8A is the same as that of FIG. 4. FIG. 8A also illustrates an attribute display screen pertaining to the jitter tolerance of the receiving element, or an attribute of the jitter pass element model 7, and FIG. 8B illustrates an example of the plot of the jitter tolerance of the receiving element.

In this example, the jitter transfer function value calculation unit 13 extracts the jitter tolerance of Point 3 to Point 4 from the frequency characteristic of the jitter tolerance of the receiving element as the minimum jitter tolerance. According to this minimum jitter tolerance extraction processing, it is possible to extract the minimum jitter tolerance from the change points of the jitter tolerance of the receiving element which are input as parameters, by using a typical MIN function.

Next, the jitter transfer function value calculation unit 13 performs target jitter frequency extraction processing to extract a frequency of the minimum jitter tolerance which is extracted by the minimum jitter tolerance extraction processing, as a target jitter frequency. This target jitter frequency extraction processing is performed for the following two reasons:

(1) Jitter pass elements typically have the characteristic that the jitter transfer function value increases with decreasing frequency; and
(2) Receiving elements having a built-in CDR typically decrease in jitter tolerance with increasing jitter frequency, and show a constant tolerance value above a certain frequency.

The specific calculation formula for the target jitter frequency extraction processing is given by the following:

Target jitter frequency = MIN(frequencies at minimum jitter tolerance extracted by the minimum jitter tolerance extraction processing).

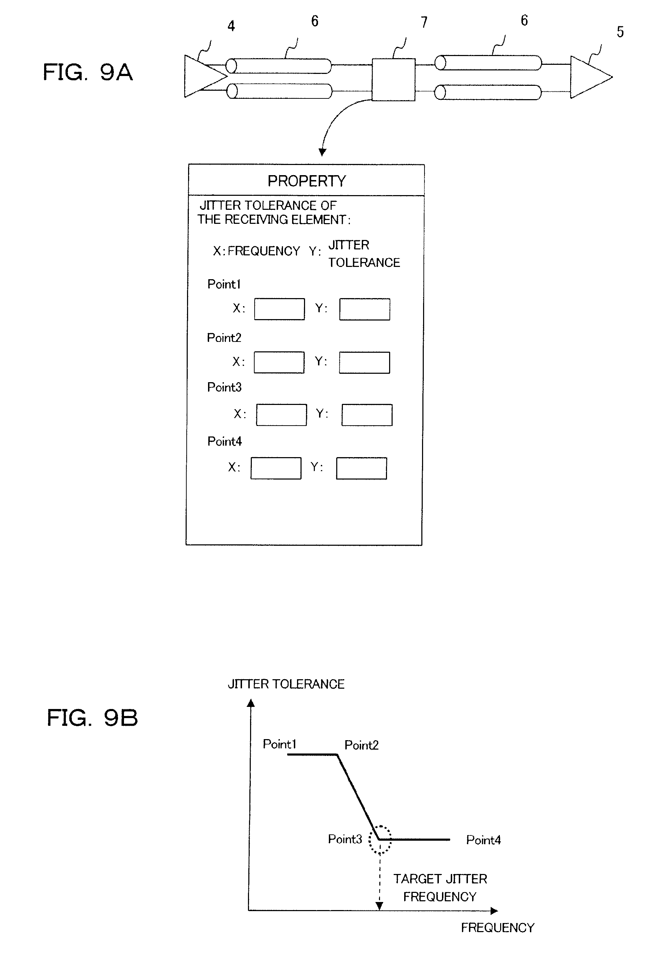

FIG. 9 is a diagram illustrating an example of the target jitter frequency extraction processing according to the first embodiment. The simulation model illustrated in this diagram is the same as that of FIG. 4. FIG. 9A illustrates an attribute display screen pertaining to the jitter tolerance of the receiving element, and FIG. 9B illustrates an example of the plot of the jitter tolerance of the receiving element.

In this example, the jitter transfer function value calculation unit 13 extracts the frequency of Point 3, which is the minimum frequency among those of Point 3 to Point 4 with the minimum jitter tolerance, as the target jitter frequency.

According to this target jitter frequency extraction processing, it is possible to narrow the change points of the jitter tolerance of the receiving element which are input as parameters, down to ones pertaining to the minimum jitter tolerance based on the general tendency on the jitter characteristics of jitter pass elements and receiving elements. Then, the frequency to be subjected to the jitter transfer function value calculation can be extracted therefrom by using an ordinary MIN function.

Next, the jitter transfer function value calculation unit 13 performs target jitter transfer function value calculation processing to calculate the jitter transfer function value of the relevant element at the target jitter frequency which is extracted by the target jitter frequency extraction processing. Here, the jitter transfer function value calculation unit 13 calculates the jitter transfer function value at the target jitter frequency by means of linear approximation using the plot of the jitter transfer function which is input as parameters.

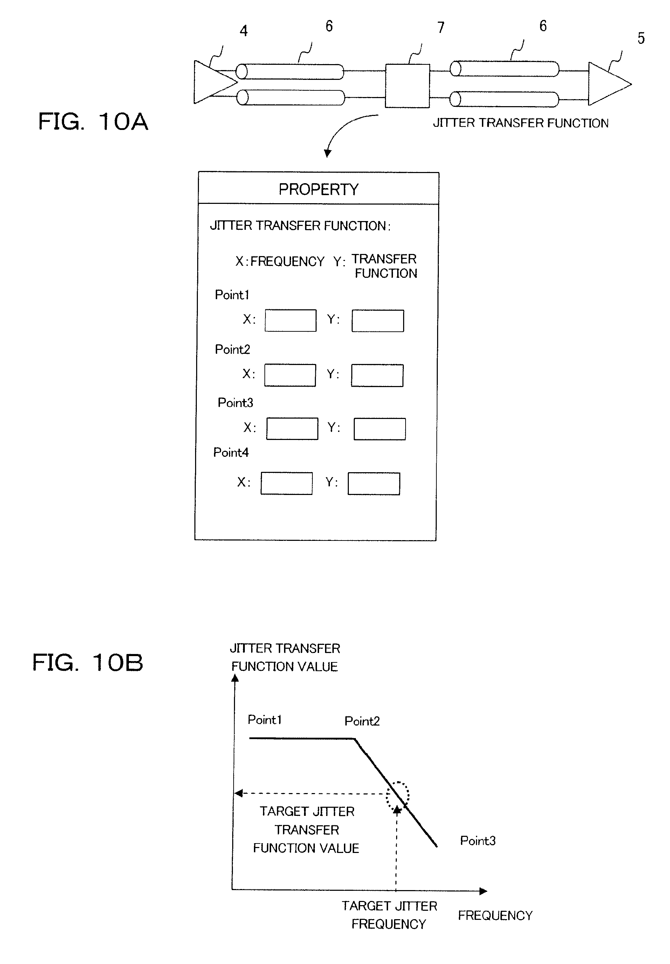

FIG. 10 is a diagram illustrating an example of the target jitter transfer function value calculation processing according to the first embodiment. The simulation model illustrated in FIG. 10A is the same as that of FIG. 4. FIG. 10A also illustrates an attribute display screen pertaining to the jitter transfer function, or an attribute of the jitter pass element model 7, and FIG. 10B illustrates an example of the plot of the jitter transfer function.

In this example, the jitter transfer function value calculation unit 13 calculates the target jitter transfer function value, i.e., the value of the jitter transfer function at the target jitter frequency (Point 3) by means of linear approximation (interpolation) between Point 2 and Point 3.

The output jitter amount calculation processing will be described below.

The output jitter amount calculation unit 14 calculates the amount of output jitter based on the numerical values acquired. The formula for calculating the amount of output jitter is given by the following:

(The output jitter of the jitter pass element) = {(the output jitter of the sending element in the preceding stage) + (transmission line jitter)} × (jitter transfer function value) + (additional jitter).

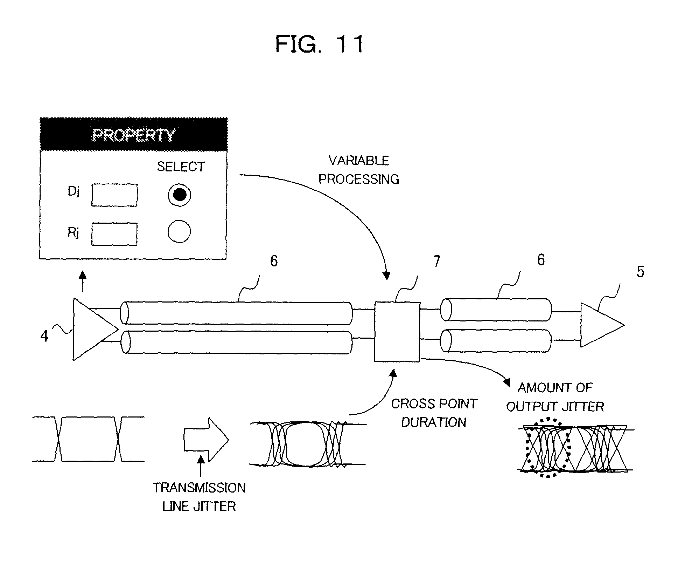

FIG. 11 is a diagram illustrating an example of the output jitter amount calculation processing according to the first embodiment. The simulation model illustrated in FIG. 11 is the same as that of FIG. 4. FIG. 11 illustrates an attribute display screen of the sending element, the output waveform of the sending element, the input waveform of the relevant element, and the output waveform of the relevant element. Among the attributes of the sending element in this diagram, the Dj and Rj values are set in the sending element model. The "select" indicates that the value is set as an attribute of the relevant element by the parameter set processing. The output jitter amount calculation processing makes it possible to incorporate the formula for calculating the amount of output jitter into the simulation model, thereby calculating the amount of jitter to be output from the jitter pass element and expressing the behavior of the same.

Next, the output waveform generation processing will be described.

The jitter pass element model 7 includes an output buffer model and a waveform display function as the output waveform generation unit 15. The output buffer model generates a waveform. The waveform display function adds the amount of output jitter calculated by the output jitter amount calculation processing to the generated waveform, thereby generating an output waveform.

The output buffer model is configured as an ordinary behavior model which is composed of current sources and resistances. Behavior models express amplitudes and output impedances by adjusting the current sources and resistances, and are incapable of jitter expression. The output waveform generation unit 15 of the present embodiment therefore provides a pseudo-expression of the jitter phenomenon by using the waveform display function.

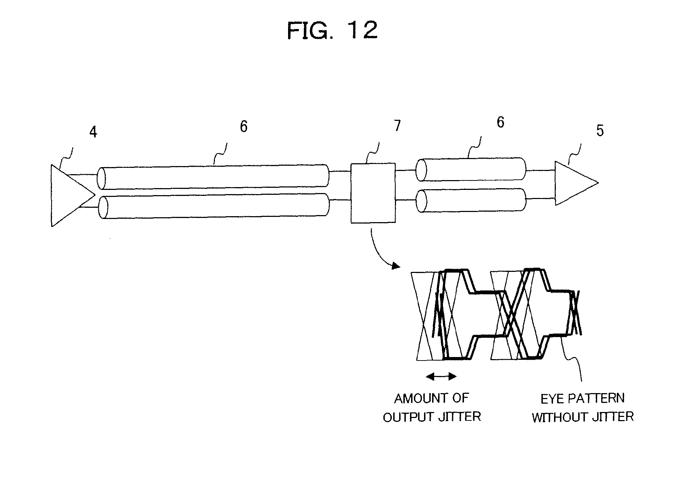

FIG. 12 is a diagram illustrating an example of the output waveform generation processing according to the first embodiment. The simulation model illustrated in FIG. 12 is the same as that of FIG. 4. FIG. 12 also illustrates an example of the output waveform of the jitter pass element model 7. Here, the output waveform generation unit 15 superimposes jitter-free waveforms on each other to generate an eye pattern, and thickens the eye pattern into an output waveform as much as the amount of output jitter in the direction of the time axis.

One of the conventional techniques for expressing the behavior of a jitter pass element is to use transistor models. Elements having a jitter-suppressing effect, however, require transistor models of vast scale to model with. An enormous amount of simulation time is required to express the frequency dependence of PLLs (Phase Locked Loops) or the like. It has thus net been possible to practice the technique. According to the present embodiment, it is possible to express a jitter pass element with a behavior model and perform simulations thereon.

The present embodiment also makes it possible to verify an entire signal transmission system including a jitter pass element by a single circuit simulation, thereby reducing the circuit simulation time of a signal transmission system with high speed signals to or below 1/10.

**[Second Embodiment]**

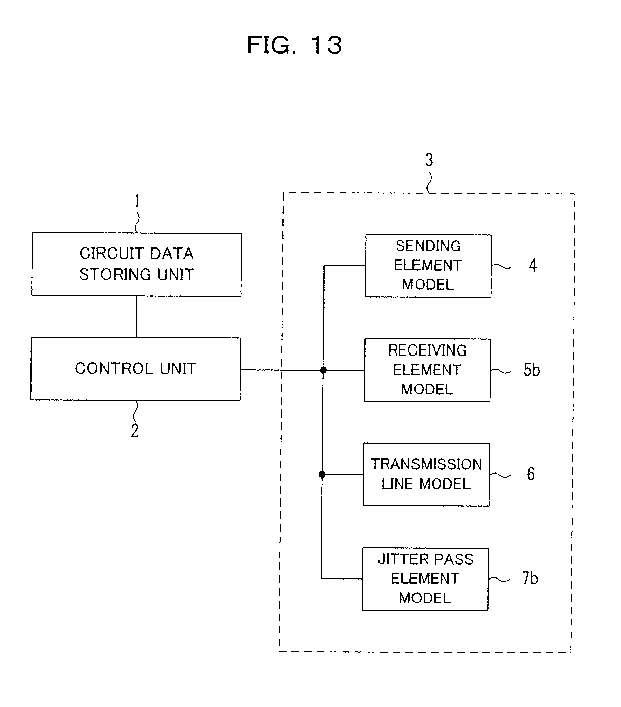

FIG. 13 is a block diagram illustrating an example of the configuration of a circuit simulation apparatus according to a second embodiment of the present invention. In this diagram, the same reference numerals as in FIG. 1 represent components identical or equivalent to those illustrated in FIG. 1, and description thereof will be omitted. As compared to the circuit simulation apparatus in FIG. 1, the circuit simulation apparatus in this diagram includes a receiving element model 5b instead of the receiving element model 5, and a jitter pass element model 7b instead of the jitter pass element model 7.

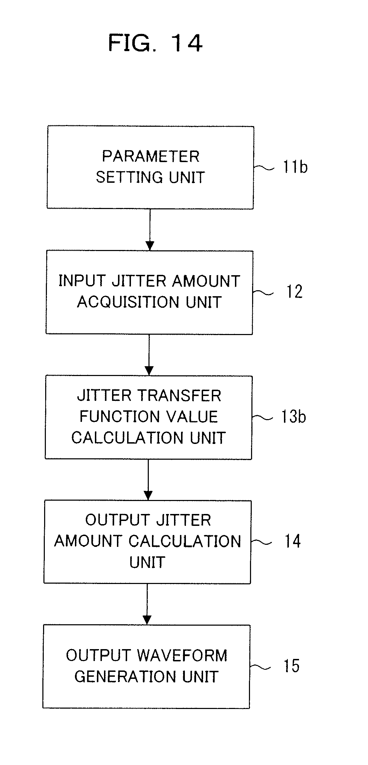

FIG. 14 is a block diagram illustrating an example of the configuration of the jitter pass element model 7b according to the second embodiment. In this diagram, the same reference numerals as in FIG. 2 represent components identical or equivalent to those illustrated in FIG. 2, and description thereof will be omitted. As compared to the jitter pass element model 7, the jitter pass element model 7b includes a parameter setting unit 11b instead of the parameter setting unit 11, and a jitter transfer function value calculation unit 13b instead of the jitter transfer function value calculation unit 13.

The circuit simulation apparatus according to the present embodiment makes the same operation as in the first embodiment, with only differences in the contents of the parameter set processing and the jitter transfer function value calculation processing.

In the parameter set processing of the first embodiment, the parameter setting unit 11 sets the user-input information pertaining to the jitter tolerance of the receiving element into the jitter pass element model 7. In the jitter transfer function value calculation processing of the first embodiment, the jitter transfer function value calculation unit 13 acquires the jitter tolerance of the receiving element which is set in the jitter pass element model 7, and calculates the jitter transfer function value of the jitter pass element. This technique, however, makes it inconvenient to use the models as a library since the information needs to be input each time the receiving element is changed.

The parameter set processing according to the present embodiment will be described below.

The parameter setting unit 11b does not set the parameters pertaining to the jitter tolerance of the receiving element as an attribute of the jitter pass element model 7b. Instead, the receiving element model 5b sets the user-input parameters pertaining to the jitter tolerance of the receiving element as an attribute of the receiving element model 5b.

Now, description will be given of the jitter transfer function value calculation processing according to the present embodiment.

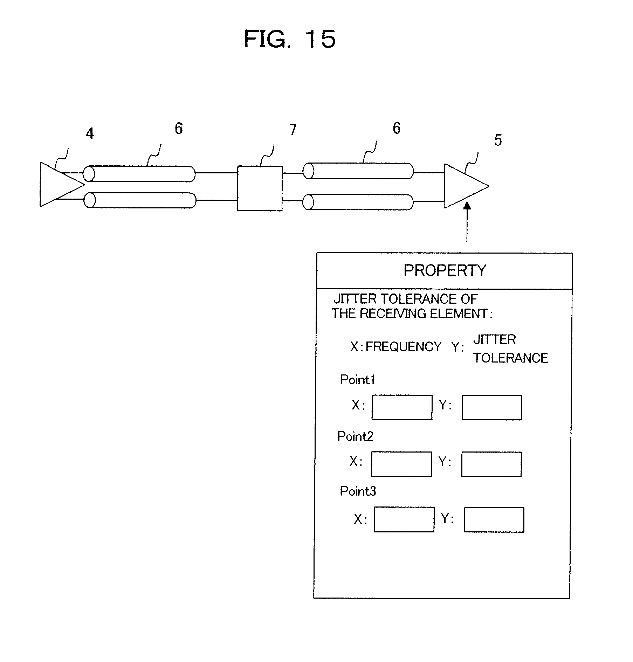

FIG. 15 is a diagram illustrating an example of the jitter transfer function value calculation processing according to the second embodiment. The simulation model illustrated in FIG. 15 is the same as that of FIG. 4. FIG. 15 illustrates a screen for displaying jitter tolerance which is an attribute of the receiving element.

In the jitter transfer function value calculation processing of the present embodiment, the jitter transfer function value calculation unit 13b identifies the receiving element model connected to the subsequent stage of the relevant element, acquires the receiving element's jitter tolerance which is set in the receiving element model, and calculates the jitter transfer function value of the jitter pass element.

According to the present embodiment, the information on the characteristics of the element models is set into the respective models. This facilitates utilizing the models as a library.

**[Third Embodiment]**

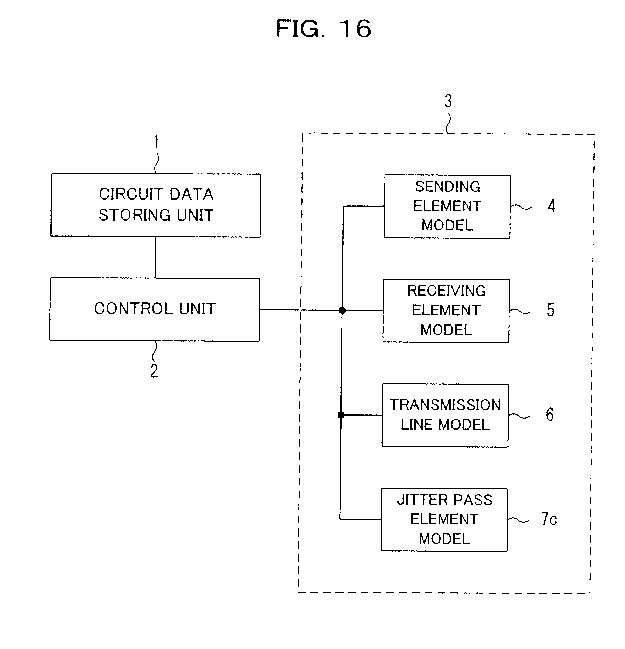

FIG. 16 is a block diagram illustrating an example of the configuration of a circuit simulation apparatus according to a third embodiment of the present invention. In this diagram, the same reference numerals as in FIG. 1 represent components identical or equivalent to those illustrated in FIG. 1, and description thereof will be omitted. As compared to the circuit simulation apparatus in FIG. 1, the circuit simulation apparatus in this diagram includes a jitter pass element model 7c instead of the jitter pass element model 7.

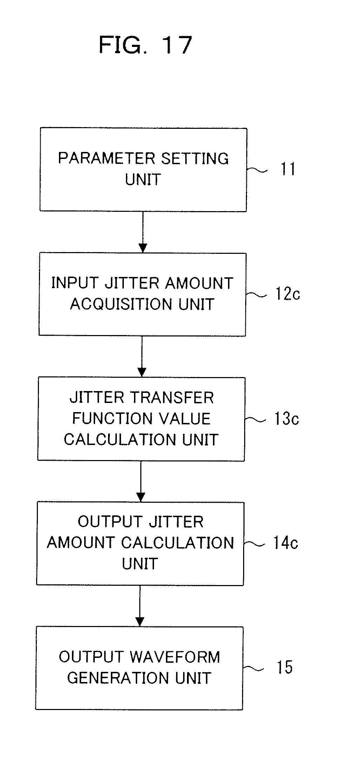

FIG. 17 is a block diagram illustrating an example of the configuration of the jitter pass element model 7c according to the third embodiment. In this diagram, the same reference numerals as in FIG. 2 represent components identical or equivalent to those illustrated in FIG. 2, and description thereof will be omitted. As compared to the jitter pass element model 7, the jitter pass element model 7c includes an input jitter amount acquisition unit 12c instead of the input jitter amount acquisition unit 12, a jitter transfer function value calculation unit 13c instead of the jitter transfer function value calculation unit 13, and an output jitter amount calculation unit 14c instead of the output jitter amount calculation unit 14.

In the circuit simulation apparatus according to the first embodiment, the characteristic of the jitter pass element is expressed by using the numerical values that are defined by the sending element in the preceding stage and the receiving element in the subsequent stage. An accurate expression of the jitter behavior, however, requires that the jitter be analyzed for frequency components.

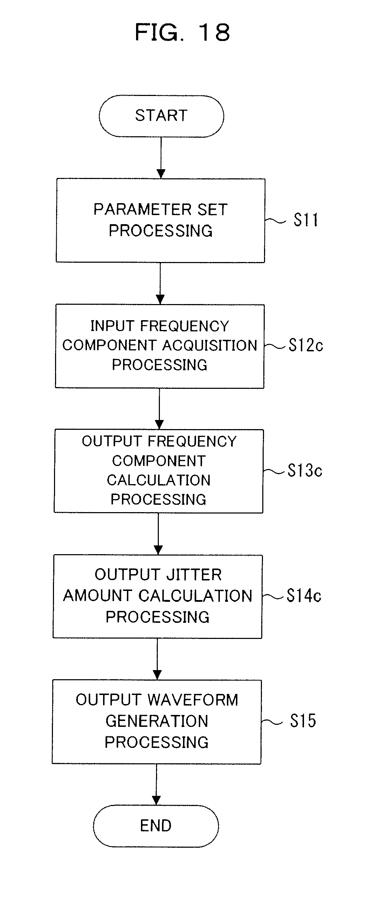

FIG. 18 is a flowchart illustrating an example of the operation of the jitter pass element model 7c according to the third embodiment. The parameter setting unit 11 performs the same parameter set processing as in the first embodiment (S11). Next, the input jitter amount acquisition unit 12c performs input frequency component acquisition processing for acquiring the frequency components of the jitter input to the relevant element (S12c). Then, the jitter transfer function value calculation unit 13c performs output frequency component calculation processing for calculating the frequency components of jitter to be output from the relevant element by using a jitter transfer function (S13c). Subsequently, the output jitter amount calculation unit 14c performs output jitter amount calculation processing for calculating the amount of jitter to be output from the relevant element by combining the frequency components of the jitter to be output from the relevant element (S14c). Then, the output waveform generation unit 15 performs the same output waveform generation processing as in the first embodiment (S15), and ends this flow.

The input frequency component acquisition processing will be described below.

In the input frequency component acquisition processing, the input jitter amount acquisition unit 12c acquires numerical data that expresses the frequency components of the input jitter contained in the input signal of the relevant element. This numerical data includes the frequencies of the frequency components of the jitter (jitter frequencies) and energy in pairs. Hereinafter, this numerical data will be referred to as the spectrum of the jitter.

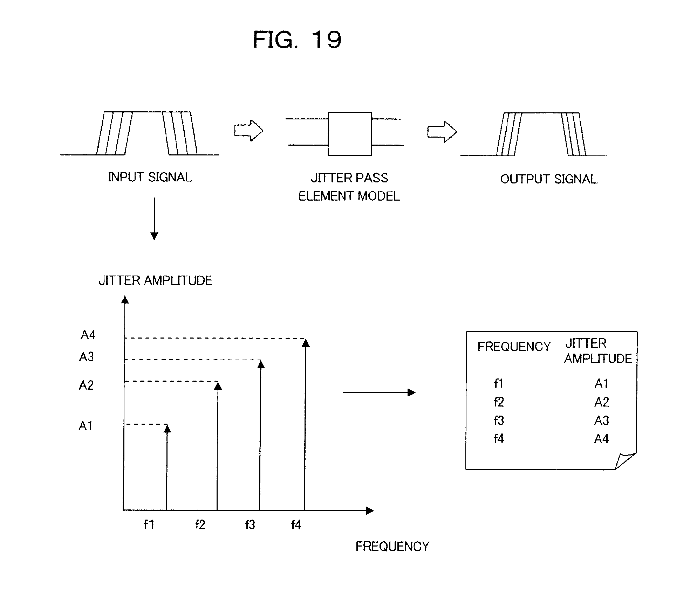

FIG. 19 is a diagram illustrating an example of the input frequency component acquisition processing according to the third embodiment. FIG. 19 illustrates an input signal to the jitter pass element model 7c, the jitter pass element model 7c, and an output signal from the jitter pass element model 7c. FIG. 19 also illustrates the plot of the spectrum of jitter contained in the input signal. FIG. 19 also illustrates the numerical data on the spectrum which is input by the user. The numerical data on the spectrum is obtained by measurement or by a simulation based on the input signal to the relevant element, i.e., the output signal of the sending element that is connected to the preceding stage. In this example, the input jitter amount acquisition unit 12c acquires frequencies f1, f2, f3, and f4, and corresponding jitter amplitudes A1, A2, A3, and A4 from the numerical data on the spectrum.

The output frequency component calculation processing will be described below.

In the output frequency component calculation processing, the jitter transfer function value calculation unit 13c calculates the energy of the jitter to be output from the jitter pass element (output jitter energy) with respect to each of the jitter frequencies based on the spectrum of the input jitter and the jitter transfer function. The formula for calculating the output jitter energy at f, where f is the jitter frequency, is given by the following:

$$\text{Output jitter energy}(f) = \text{energy}(f) \text{ of the input jitter} \times \text{jitter transfer function}(f).$$

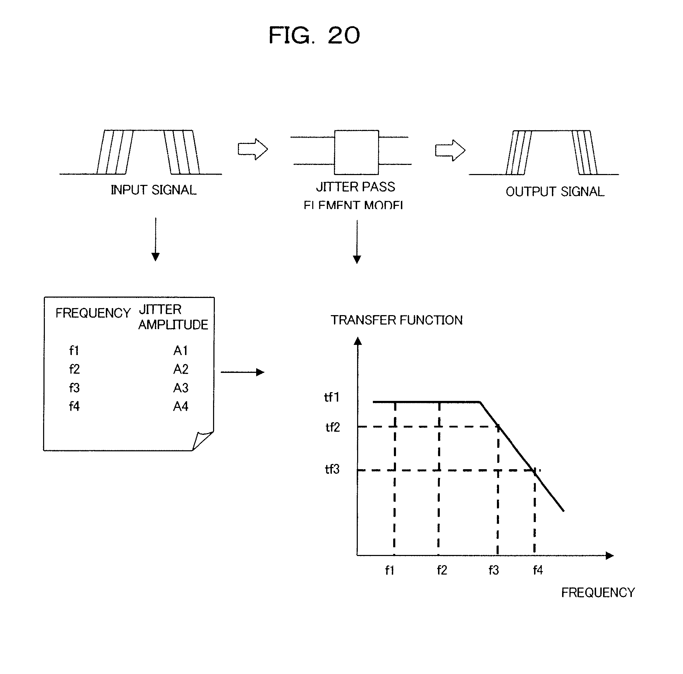

FIG. 20 is a diagram illustrating an example of the output frequency component calculation processing according to the third embodiment. FIG. 20 illustrates an input signal to the jitter pass element model 7c, the jitter pass element model 7c, and an output signal from the jitter pass element model 7c. FIG. 20 also illustrates numerical data on the spectrum. FIG. 20 also illustrates the jitter transfer function. Here, the jitter transfer function values at frequencies f1, f2, f3, and f4 shall be tf1, tf1, tf2, and tf3, respectively.

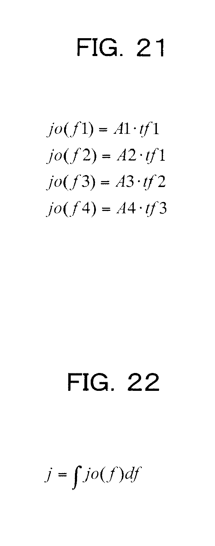

FIG. 21 illustrates equations for an example of the output frequency component calculation processing according to the third embodiment. The output jitter energies jo(f1), jo(f2), jo(f3), and jo(f4) at the respective frequencies f1, f2, f3, and f4 are determined by these functions.

Next, the output jitter amount calculation processing will be described.

In the output jitter amount calculation processing, the output jitter amount calculation unit 14c integrates the frequency components of the output jitter calculated by the output frequency component calculation processing with respect to the frequency across the entire pass band, thereby calculating the amount of output jitter along the time axis. FIG. 22 illustrates an equation for an example of the output jitter amount calculation processing according to the third embodiment. The amount of output jitter j is calculated by integrating jo(f) with respect to the frequency across the entire pass band.

According to the present embodiment, the frequency analysis function is incorporated into the jitter pass element model 7c so that simulations can be made with higher precision.

Each of the foregoing embodiments may be applied to techniques of signal waveform analysis for calculating a comprehensive transmission margin with consideration given to factors that can deteriorate transmission quality.

A program for making a computer that constitutes the circuit simulation apparatus perform the foregoing steps may be provided as a circuit simulation program. The program may be stored in a computer-readable recording medium so that it can be executed by a computer that constitutes the circuit simulation apparatus. Examples of the computer-readable recording medium include: internal storage devices implemented inside the computer such as ROM and RAM; portable recording media such as a CD-ROM, flexible disk, DVD disk, magneto-optical disk, and IC card; databases for storing computer programs, and other computers and their databases; and even online transmission media.

The present invention may be practiced in various other forms without departing from the essential characteristics thereof. The foregoing embodiments are therefore to be considered in all respects as illustrative and not restrictive. The scope of the invention is indicated by the appended claims rather than by the foregoing description. All changes, improvements, substitutions, and modifications which come within the meaning and range of equivalency of the claims are also intended to be embraced in the scope of the invention.

According to the circuit simulation apparatus, the medium containing a circuit simulation program, and the circuit simulation method disclosed therein, it is possible to perform a circuit simulation on a circuit including a jitter pass element with high efficiency.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiment(s) of the present inventions have been described in detail, it should be understood that the various changes, substitutions, and alterations could be made hereto without departing from the scope of the invention.

In any of the above aspects, the various features may be implemented in hardware, or as software modules running on one or more processors. Features of one aspect may be applied to any o the other aspects.

The invention also provides a computer program or a computer program product for carrying out any of the methods described herein, and a computer readable medium having stored thereon a program for carrying out any of the methods described herein. A computer program embodying the invention may be stored on a computer-readable medium, or it could, for example, be in the form of a signal such as a downloadable data signal provided from an Internet website, or it could be in any other form.

The invention extends to the following statements:

1. A medium containing a circuit simulation program in a computer-readable fashion, the circuit simulation program causing a computer to execute a circuit simulation using a jitter pass element model that is a model of a jitter pass element, the jitter pass element being an element for jitter to pass through, the program causing the computer to execute:

acquiring information on a jitter transfer function of the jitter pass element with respect to a predetermined frequency band;
acquiring information pertaining to input jitter to the jitter pass element;
determining a jitter frequency based on the information on the jitter transfer function or the information pertaining to the input jitter acquired to calculate a jitter transfer function value which is a value of the acquired jitter transfer function at the jitter frequency; and
calculating output jitter from the jitter pass element based on the information pertaining to the input jitter acquired and the jitter transfer function value calculated.

2. The medium containing a circuit simulation program according to statement 1, wherein
a jitter tolerance characteristic is further acquired of a receiving element connected to a subsequent stage of the jitter pass element, and
the jitter frequency is determined based on the jitter tolerance characteristic acquired.
3. The medium containing a circuit simulation program according to statement 2, wherein
the jitter tolerance characteristic of the receiving element is acquired from a model of the receiving element.
4. The medium containing a circuit simulation program according to any of statements 1 to 3, wherein
for the information on the input jitter, information on jitter output is acquired from a sending element connected to a preceding stage of the jitter pass element based on a model of the sending element.
5. The medium containing a circuit simulation program according to statement 4, wherein
a target jitter type of the jitter pass element is acquired, and the amount of jitter of the jitter type output from the sending element is acquired based on the model of the sending element.
6. The medium containing a circuit simulation program according to any of statements 1 to 5, wherein
for the jitter frequency, a frequency is determined that minimizes the value of the acquired jitter transfer function.
7. The medium containing a circuit simulation program according to any of statements 1 to 6, wherein
information on a frequency component of jitter output from a sending element connected to a preceding stage of the jitter pass element is acquired as information on a frequency component of the input jitter, and
the jitter frequency is determined based on the information on the frequency component of the input jitter acquired.
8. The medium containing a circuit simulation program according to any of statements 1 to 7, wherein
frequency components of the output jitter are calculated based on the information on the frequency component of the input jitter and the jitter transfer function value, and the amount of the output jitter is calculated by combining the frequency components of the output jitter.
9. The medium containing a circuit simulation program according to any of statements 1 to 8, wherein
an output waveform of the jitter pass element is further generated based on the output jitter calculated.
10. The medium containing a circuit simulation program according to statement 9, wherein
an eye pattern to be output from the jitter pass element is generated, and the output jitter is added to the eye pattern to generate the output waveform.
11. The medium containing a circuit simulation program according to any of statements 1 to 10, wherein
information on a change point of the jitter transfer function is acquired.
12. The medium containing a circuit simulation program according to any of statements 1 to 11, wherein
a function is acquired that is all-pass throughout the predetermined frequency band as the jitter transfer function if it is determined based on an input from outside that the jitter pass element is free of jitter amplification or suppression.

## Claims

1. A circuit simulation apparatus for performing a circuit simulation using a jitter pass element model that is a model of a jitter pass element, the jitter pass element being an element for jitter to pass through, the apparatus comprising:

a first acquisition unit that acquires information on a jitter transfer function of the jitter pass element with respect to a predetermined frequency band;
a second acquisition unit that acquires information pertaining to input jitter to the jitter pass element;

a first calculation unit that determines a jitter frequency based on the information acquired by the first acquisition unit or the second acquisition unit to calculate a jitter transfer function value which is a value of the jitter transfer function acquired by the first acquisition unit at the jitter frequency; and

a second calculation unit that calculates output jitter from the jitter pass element based on the information pertaining to the input jitter acquired by the second acquisition unit and the jitter transfer function value calculated by the first calculation unit.

2. The circuit simulation apparatus according to claim 1, wherein
the first acquisition unit further acquires a jitter tolerance characteristic of a receiving element connected to a subsequent stage of the jitter pass element, and
the first calculation unit determines the jitter frequency based on the jitter tolerance characteristic acquired by the first acquisition unit.

3. The circuit simulation apparatus according to claim 2, wherein
the first acquisition unit acquires the jitter tolerance characteristic of the receiving element from a model of the receiving element.

4. The circuit simulation apparatus according to any of claims 1 to 3, wherein
for the information on the input jitter, the second acquisition unit further acquires information on jitter output from a sending element connected to a preceding stage of the jitter pass element based on a model of the sending element.

5. The circuit simulation apparatus according to claim 4, wherein
the second acquisition unit acquires a target jitter type of the jitter pass element, and acquires the amount of jitter of the jitter type output from the sending element based on the model of the sending element.

6. The circuit simulation apparatus according to any of the preceding claims, wherein
for the jitter frequency, the first calculation unit determines a frequency that minimizes the value of the jitter transfer function acquired by the first acquisition unit.

7. The circuit simulation apparatus according to any of the preceding claims, wherein
for information on a frequency component of the input jitter, the second acquisition unit acquires information on a frequency component of jitter output from a sending element connected to a preceding stage of the jitter pass element; and
the first calculation unit determines the jitter frequency based on the information on the frequency component of the input jitter acquired by the second acquisition unit.

8. The circuit simulation apparatus according to any of the preceding claims, wherein
the second calculation unit calculates frequency components of the output jitter based on the information on the frequency component of the input jitter and the jitter transfer function value, and calculates the amount of the output jitter by combining the frequency components of the output jitter calculated.

9. The circuit simulation apparatus according to any of the preceding claims, further comprising
a waveform generation unit that generates an output waveform of the jitter pass element based on the output jitter calculated by the second calculation unit.

10. The circuit simulation apparatus according to claim 9, wherein
the waveform generation unit generates an eye pattern to be output from the jitter pass element, and adds the output jitter to the eye pattern to generate the output waveform.

11. The circuit simulation apparatus according to any of the preceding claims,, wherein
the first acquisition unit acquires information on a change point of the jitter transfer function.

12. The circuit simulation apparatus according to any of the preceding claims, wherein
the first acquisition unit acquires a function that is all-pass throughout the predetermined frequency band as the jitter transfer function if the first acquisition unit determines based on an input from outside that the jitter pass element is free of jitter amplification or suppression.

13. A medium containing a circuit simulation program in a computer-readable fashion, the circuit simulation program causing a computer to execute a circuit simulation using a jitter pass element model that is a model of a jitter pass element, the jitter pass element being an element for jitter to pass through, the program causing the computer to execute:

acquiring information on a jitter transfer function of the jitter pass element with respect to a predetermined frequency band;

acquiring information pertaining to input jitter to the jitter pass element;

determining a jitter frequency based on the information on the jitter transfer function or the information pertaining to the input jitter acquired to calculate a jitter transfer function value which is a value of the acquired jitter transfer function at the jitter frequency; and

calculating output jitter from the jitter pass element based on the information pertaining to the input jitter acquired and the jitter transfer function value calculated.

14. The medium containing a circuit simulation program according to claim 13, wherein

information on a frequency component of jitter output from a sending element connected to a preceding stage of the jitter pass element is acquired as information on a frequency component of the input jitter, and

the jitter frequency is determined based on the information on the frequency component of the input jitter acquired.

15. A circuit simulation method for performing a circuit simulation using a jitter pass element model that is a model of a jitter pass element, the jitter pass element being an element for jitter to pass through, the method comprising:

acquiring information on a jitter transfer function of the jitter pass element with respect to a predetermined frequency band;

acquiring information pertaining to input jitter to the jitter pass element;

determining a jitter frequency based on the information on the jitter transfer function or the information pertaining to the input jitter acquired to calculate a jitter transfer function value which is a value of the acquired jitter transfer function at the jitter frequency; and

calculating output jitter from the jitter pass element based on the information pertaining to the input jitter acquired and the jitter transfer function value calculated.

FIG. 1

# FIG. 2

PARAMETER SETTING UNIT — 11

↓

INPUT JITTER AMOUNT ACQUISITION UNIT — 12

↓

JITTER TRANSFER FUNCTION VALUE CALCULATION UNIT — 13

↓

OUTPUT JITTER AMOUNT CALCULATION UNIT — 14

↓

OUTPUT WAVEFORM GENERATION UNIT — 15

# FIG. 3

START

↓

PARAMETER SET
PROCESSING — S11

↓

INPUT JITTER AMOUNT
ACQUISITION
PROCESSING — S12

↓

JITTER TRANSFER
FUNCTION VALUE
CALCULATION
PROCESSING — S13

↓

OUTPUT JITTER
AMOUNT CALCULATION
PROCESSING — S14

↓

OUTPUT WAVEFORM
GENERATION
PROCESSING — S15

↓

END

# FIG. 4

PROPERTY

INPUT AMPLITUDE:

[                    ]

TARGET JITTER TYPE:

Dj:          ●

Rj:          ○

OUTPUT AMPLITUDE:

[                    ]

trtf:

[                    ]

ADDITIONAL JITTER:

[                    ]

JITTER TRANSFER FUNCTION

● FREQUENCY DEFINITION

X:FREQUENCY  Y: TRANSFER FUNCTION

Point1

X: [        ]  Y: [        ]

Point2

X: [        ]  Y: [        ]

Point3

X: [        ]  Y: [        ]

○ NO AMPLIFICATION /SUPPRESSION

JITTER TOLERANCE
THE RECEIVING ELEMENT:

X:FREQUENCY  Y: JITTER TOLERANCE

Point1

X: [        ]  Y: [        ]

Point2

X: [        ]  Y: [        ]

Point3

X: [        ]  Y: [        ]

# FIG. 5

PROPERTY

SELECT

Dj ◉

Rj ○

VARIABLE PROCESSING

6

7

6

5

4

TRANSMISSION
LINE JITTER

# FIG. 6

$$T4=T3-(T2-T1) \quad \sim S24$$

# FIG. 7

```
        START

NARROW DOWN
TARGET PLOTS          S21

DETECT MINIMUM TIME   S22

DETECT MAXIMUM TIME   S23

CALCULATE CROSS
POINT DURATION        S24

        END
```

FIG. 8A

PROPERTY

JITTER TOLERANCE OF
THE RECEIVING ELEMENT:

X : FREQUENCY   Y : JITTER TOLERANCE

Point1

X: [    ]   Y: [    ]

Point2

X: [    ]   Y: [    ]

Point3

X: [    ]   Y: [    ]

Point4

X: [    ]   Y: [    ]

FIG. 8B

JITTER TOLERANCE

Point1   Point2

MINIMUM
JITTER
TOLERANCE

Point3   Point4

FREQUENCY

FIG. 9A

PROPERTY

JITTER TOLERANCE OF
THE RECEIVING ELEMENT:

X: FREQUENCY   Y: JITTER
                  TOLERANCE

Point1
    X: [      ]   Y: [      ]

Point2
    X: [      ]   Y: [      ]

Point3
    X: [      ]   Y: [      ]

Point4
    X: [      ]   Y: [      ]

FIG. 9B

JITTER TOLERANCE

Point1       Point2

Point3       Point4

TARGET JITTER
FREQUENCY

FREQUENCY

**FIG. 10A**

JITTER TRANSFER FUNCTION

PROPERTY

JITTER TRANSFER FUNCTION :

X : FREQUENCY   Y : TRANSFER
                    FUNCTION

Point1

X :          Y :

Point2

X :          Y :

Point3

X :          Y :

Point4

X :          Y :

**FIG. 10B**

JITTER TRANSFER
FUNCTION VALUE

Point1          Point2

TARGET JITTER
TRANSFER
FUNCTION VALUE

Point3

TARGET JITTER
FREQUENCY                FREQUENCY

# FIG. 11

PROPERTY

SELECT

Dj

Rj

VARIABLE
PROCESSING

6

7

6

5

4

AMOUNT OF
OUTPUT JITTER

CROSS POINT
DURATION

TRANSMISSION
LINE JITTER

FIG. 12

AMOUNT OF
OUTPUT JITTER

EYE PATTERN
WITHOUT JITTER

FIG. 13

# FIG. 14

```
┌─────────────────────────┐
│     PARAMETER           │
│     SETTING UNIT        │ ～ 11b
└─────────────────────────┘
            │
            ▼
┌─────────────────────────┐
│  INPUT JITTER AMOUNT    │
│  ACQUISITION UNIT       │ ～ 12
└─────────────────────────┘
            │
            ▼
┌─────────────────────────┐
│  JITTER TRANSFER        │
│  FUNCTION VALUE         │ ～ 13b
│  CALCULATION UNIT       │
└─────────────────────────┘
            │
            ▼
┌─────────────────────────┐
│  OUTPUT JITTER          │
│  AMOUNT CALCULATION     │ ～ 14
│  UNIT                   │
└─────────────────────────┘
            │
            ▼
┌─────────────────────────┐
│  OUTPUT WAVEFORM        │
│  GENERATION UNIT        │ ～ 15
└─────────────────────────┘
```

# FIG. 15

PROPERTY

JITTER TOLERANCE OF
THE RECEIVING ELEMENT :

X : FREQUENCY  Y : JITTER
                   TOLERANCE

Point1

X : [    ]  Y : [    ]

Point2

X : [    ]  Y : [    ]

Point3

X : [    ]  Y : [    ]

FIG. 16

# FIG. 17

```
┌─────────────────────────┐
│   PARAMETER SETTING      │ ~ 11
│        UNIT              │
└─────────────────────────┘
            │
            ▼
┌─────────────────────────┐
│  INPUT JITTER AMOUNT     │ ~ 12c
│   ACQUISITION UNIT       │
└─────────────────────────┘
            │
            ▼
┌─────────────────────────┐
│   JITTER TRANSFER        │
│  FUNCTION VALUE          │ ~ 13c
│  CALCULATION UNIT        │
└─────────────────────────┘
            │
            ▼
┌─────────────────────────┐
│   OUTPUT JITTER          │
│ AMOUNT CALCULATION       │ ~ 14c
│        UNIT              │
└─────────────────────────┘
            │
            ▼
┌─────────────────────────┐
│   OUTPUT WAVEFORM        │ ~ 15
│  GENERATION UNIT         │
└─────────────────────────┘
```

# FIG. 18

START

PARAMETER SET
PROCESSING — S11

INPUT FREQUENCY
COMPONENT ACQUISITION — S12c
PROCESSING

OUTPUT FREQUENCY
COMPONENT
CALCULATION — S13c
PROCESSING

OUTPUT JITTER
AMOUNT CALCULATION — S14c
PROCESSING

OUTPUT WAVEFORM
GENERATION — S15
PROCESSING

END

# FIG. 19

INPUT SIGNAL

JITTER PASS
ELEMENT MODEL

OUTPUT SIGNAL

JITTER AMPLITUDE

| FREQUENCY | JITTER AMPLITUDE |
|-----------|------------------|
| f1 | A1 |
| f2 | A2 |
| f3 | A3 |
| f4 | A4 |

FREQUENCY

# FIG. 20

INPUT SIGNAL

JITTER PASS
ELEMENT MODEL

OUTPUT SIGNAL

| FREQUENCY | JITTER AMPLITUDE |
|-----------|------------------|
| f1 | A1 |
| f2 | A2 |
| f3 | A3 |
| f4 | A4 |

TRANSFER FUNCTION

tf1
tf2
tf3

f1  f2  f3  f4

FREQUENCY

## FIG. 21

$$jo(f1) = A1 \cdot tf1$$
$$jo(f2) = A2 \cdot tf1$$
$$jo(f3) = A3 \cdot tf2$$
$$jo(f4) = A4 \cdot tf3$$

## FIG. 22

$$j = \int jo(f)df$$

Europäisches
Patentamt

European
Patent Office

Office européen
des brevets

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WENDEMAGEGNEHU BEYENE ED - ANONYMOUS: "Modeling and Analysis Techniques of Jitter Enhancement Across High-Speed Interconnect Systems" ELECTRICAL PERFORMANCE OF ELECTRONIC PACKAGING, 2007 IEEE, IEEE, PI, 1 October 2007 (2007-10-01), pages 29-32, XP031163564 ISBN: 978-1-4244-0883-2 * the whole document * | 1-15 | INV. G06F17/50 |
| A | US 7 305 025 B2 (YAMAGUCHI TAKAHIRO [JP] ET AL) 4 December 2007 (2007-12-04) * the whole document * | 1-15 | |
| A | STOJANOVIC V ET AL: "Modeling and analysis of high-speed links" PROCEEDINGS OF THE IEEE 2003 CUSTOM INTEGRATED CIRCUITS CONFERENCE. (CICC 2003). SAN JOSE, CA, SEPT. 21 - 24, 2003; [IEEE CUSTOM INTEGRATED CIRCUITS CONFERENCE.CICC], NEW YORK, NY : IEEE, US, vol. CONF. 25, 21 September 2003 (2003-09-21), pages 589-594, XP010671095 ISBN: 978-0-7803-7842-1 * the whole document * | 1-15 | TECHNICAL FIELDS SEARCHED (IPC) G06F |

The present search report has been drawn up for all claims

| Place of search | Date of completion of the search | Examiner |
|---|---|---|
| Munich | 15 February 2010 | Lerbinger, Klaus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

**ANNEX TO THE EUROPEAN SEARCH REPORT**
**ON EUROPEAN PATENT APPLICATION NO.**

EP 09 15 2736

This annex lists the patent family members relating to the patent documents cited in the above-mentioned European search report.
The members are as contained in the European Patent Office EDP file on
The European Patent Office is in no way liable for these particulars which are merely given for the purpose of information.

15-02-2010

| Patent document cited in search report | | Publication date | Patent family member(s) | | Publication date |
|---|---|---|---|---|---|
| US 7305025 | B2 | 04-12-2007 | DE | 10392148 T5 | 02-09-2004 |
| | | | DE | 10392318 T5 | 07-07-2005 |
| | | | WO | 03073680 A2 | 04-09-2003 |
| | | | WO | 03073115 A1 | 04-09-2003 |
| | | | JP | 4216198 B2 | 28-01-2009 |
| | | | JP | 4376064 B2 | 02-12-2009 |
| | | | JP | 2006504069 T | 02-02-2006 |
| | | | JP | 2009103717 A | 14-05-2009 |
| | | | US | 2005267696 A1 | 01-12-2005 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007292520 A
- WO 2003073680 A